# FASCICULE DE BREVET EUROPEEN

(11) **EP 1 427 000 B1**
(45) Date de publication et mention de la délivrance du brevet: **19.04.2006**
(21) Numéro de dépôt: 03300059.7
(22) Date de dépôt: 11.07.2003
(51) Int. Cl.: H01L 21/20, C30B 25/18, C30B 29/40

(54) **Croissance d'une région monocristalline d'un composé III-V sur un substrat de silicium monocristallin**
Züchtung von einem einkristallinen Bereich einer III-V-Verbindung auf einem einkristallinen Siliciumsubstrat
Growth of a single crystal region of a III-V compound on a single crystal silicon substrate

(30) Priorité: 12.07.2002 FR 0208862
(43) Date de publication de la demande: 09.06.2004
(73) Titulaire: STMicroelectronics S.A., 92120 Montrouge (FR)
(72) Inventeur: Bensahel, M. Daniel, 38100 Grenoble (FR)
(74) Mandataire: de Beaumont, Michel

(56) Documents cités:
- EP-A- 0 514 018
- WO-A-99/14804
- DE-A- 3 617 927
- US-A- 4 551 394
- US-A- 5 668 023
- US-A- 6 039 803
- PATENT ABSTRACTS OF JAPAN vol. 009, no. 023 (E-293), 30 janvier 1985 (1985-01-30) & JP 59 171115 A (OKI DENKI KOGYO KK), 27 septembre 1984 (1984-09-27)

## Description

La présente invention concerne un procédé de croissance d'une région monocristalline d'un composé III-V sur un substrat de silicium monocristallin. La présente invention concerne également le dispositif obtenu par le présent procédé. La présente invention s'applique particulièrement à la formation d'une région monocristalline d'un composé binaire d'arséniure de gallium (AsGa) sur un substrat de silicium monocristallin sur lequel sont réalisés d'autres composants semiconducteurs.

Les composés III-V sont actuellement utilisés pour réaliser des dispositifs optoélectroniques, par exemple des cellules solaires, des lasers ou des diodes, ou pour réaliser des circuits rapides.

Il est connu de faire croître par épitaxie une couche d'un composé binaire d'AsGa sur un substrat de germanium massif, le germanium et l'AsGa présentant un paramètre de maille similaire. Toutefois, lorsque l'on fait croître de l'AsGa sur un substrat de germanium monocristallin orienté, dont l'orientation est par exemple (100), la couche d'AsGa obtenue présente une structure polycristalline. En effet, l'AsGa est un composé binaire qui peut démarrer sa croissance sur un plan As ou un plan Ga. Sur la surface du germanium orienté (100), la nucléation de l'AsGa peut partir de n'importe quel point de la surface selon un plan As ou un plan Ga. Des grains d'AsGa, qui ont démarré les uns sur une face Ga et les autres sur une face As, tendent à croître et forment, en se rejoignant, des joints de grains. De tels joints de grains sont appelés domaines d'antiphase (APD) et correspondent à des régions à défauts qui sont indésirables lorsqu'on souhaite réaliser dans la couche d'AsGa des dispositifs optoélectroniques ou des circuits rapides.

Pour éviter la formation de joints de grain, la surface du germanium monocristallin massif est généralement altérée de façon à former des marches sur les bords desquelles, avec des conditions de dépôt adaptées, il est possible de faire débuter la nucléation d'AsGa préférentiellement selon le même plan As ou Ga de départ. De façon optimale, la surface du germanium massif est usinée mécaniquement, par exemple par polissage, pour obtenir une face inclinée de 6° environ par rapport aux plans de croissance (100).

Il existe actuellement un besoin pour réaliser des régions monocristallines de composés III-V, en particulier d'AsGa, sur une plaquette de silicium de façon à intégrer les dispositifs optoélectroniques ou les circuits rapides réalisés au niveau des régions d'AsGa avec les autres composants semiconducteurs réalisés sur la plaquette.

Pour ce faire, on rapporte actuellement sur la plaquette de silicium, par exemple par collage, des portions d'une couche monocristalline d'AsGa préalablement réalisée sur du germanium massif.

En effet, même s'il est connu de faire croître directement une couche de germanium monocristallin de quelques micromètres sur une plaquette de silicium monocristallin, le germanium monocristallin obtenu conserve l'information cristalline issue du silicium monocristallin et est donc orienté, le plus souvent selon l'orientation (100) qui correspond à l'orientation habituelle des plaquettes de silicium utilisées en microélectronique. Pour les mêmes raisons que celles exposées précédemment, si l'on fait croître par épitaxie un composé III-V sur la surface du germanium formé sur la plaquette de silicium, la structure obtenue est polycristalline. Or, on ne connaît pas actuellement de moyens simples pour usiner mécaniquement une couche de germanium de quelques micromètres et former des faces inclinées de 6° sur lesquelles pourrait croître un monocristal du composé III-V.

De plus, lorsqu'on fait croître du germanium sur une plaquette de silicium monocristallin "dé-orienté", c'est-à-dire dont la surface aurait été polie selon un plan incliné par rapport aux plans de croissance du silicium, on observe que le germanium tend à reprendre une orientation classique, et à ne pas conserver le caractère dé-orienté du silicium.

La présente invention vise à faire croître des régions monocristallines de composés III-V directement sur une plaquette de silicium monocristallin.

Un autre objet de la présente invention vise à obtenir un procédé de croissance de régions monocristallines de composés III-V sur une plaquette de silicium monocristallin qui soit compatible avec des procédés classiques de filières de circuits intégrés.

Pour atteindre ces objets, la présente invention prévoit un procédé de croissance d'une région monocristalline d'un composé III-V sur une surface correspondant à un plan cristallographique d'un substrat de silicium monocristallin, comprenant les étapes consistant à faire croître par épitaxie sur le substrat une couche de germanium monocristallin ; graver dans une partie de l'épaisseur de la couche de germanium une ouverture dont le fond correspond à une unique face inclinée par rapport à ladite surface ou à plusieurs faces inclinées par rapport à ladite surface ; et faire croître le composé III-V monocristallin sur le fond de l'ouverture.

Selon un mode de réalisation de l'invention, le substrat de silicium monocristallin est orienté (100) et ladite ou lesdites faces inclinées sont inclinées d'un angle de sensiblement 5 à 7 degrés par rapport à ladite surface.

Selon un mode de réalisation de l'invention, le substrat de silicium monocristallin est orienté (100) et le fond de l'ouverture comprend deux faces inclinées de sensiblement 5 à 7 degrés par rapport à ladite surface.

Selon un mode de réalisation de l'invention, le procédé comporte en outre l'étape consistant à faire croître sur le substrat de silicium monocristallin au moins une couche d'un alliage de silicium et de germanium sur laquelle on fait croître la couche de germanium.

Selon un mode de réalisation de l'invention, le procédé comporte en outre l'étape consistant à faire croître une couche d'oxyde sur la couche de germanium et à graver ladite couche d'oxyde de façon à former une zone de relief sur ladite couche d'oxyde, la forme de la surface de ladite zone de relief étant transférée par gravure dans la couche de germanium.

Selon un mode de réalisation de l'invention, l'épaisseur de la couche de germanium séparant le fond de l'ouverture et le substrat de silicium monocristallin est supérieure à 300 nanomètres.

Selon un mode de réalisation de l'invention, l'ouverture a une section dont l'aire est de quelques dizaines de micromètres carrés.

Selon un mode de réalisation de l'invention, le composé III-V est de l'arséniure de gallium.

L'invention prévoit également un dispositif comprenant un substrat de silicium monocristallin comportant une surface correspondant à un plan cristallographique recouverte d'une couche de germanium monocristallin, dans lequel la couche de germanium comporte au moins une ouverture dont la profondeur est inférieure à l'épaisseur de la couche de germanium, le fond de l'ouverture correspondant à une unique face inclinée par rapport à ladite surface ou à plusieurs faces inclinées par rapport à ladite surface, ladite ouverture contenant un composé III-V.

Selon un mode de réalisation de l'invention, un composant électronique est formé dans le composé III-V.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1D représentent des coupes de la structure que l'on cherche à obtenir à des étapes successives d'un premier mode de réalisation selon l'invention ; et
les figures 2A à 2D représentent des coupes de la structure que l'on cherche à obtenir à des étapes successives d'un second mode de réalisation selon l'invention.

La présente description sera conduite dans le cas où le composé III-V est de l'arséniure de gallium.

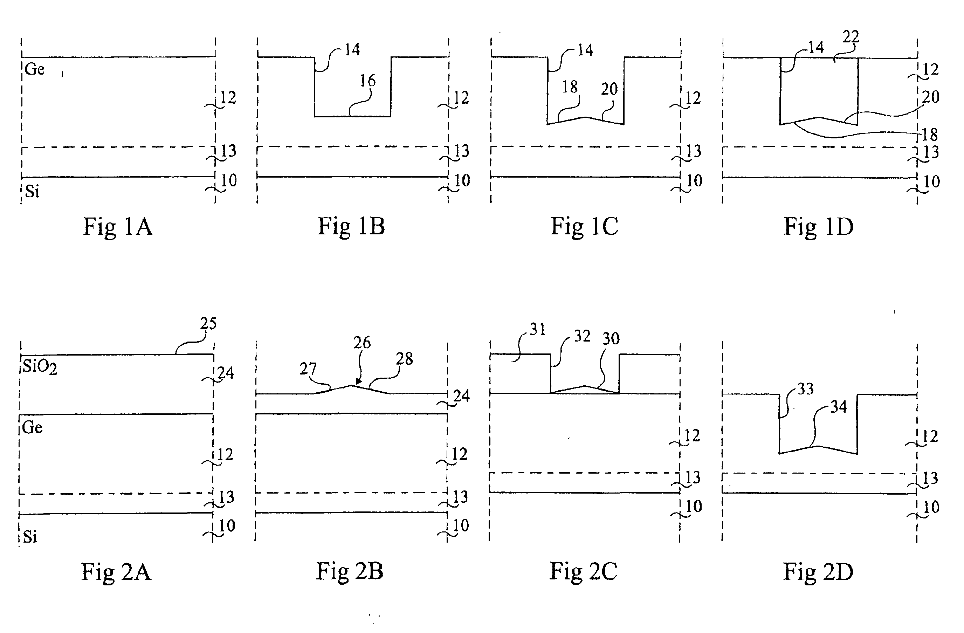

La figure 1A représente une coupe d'une portion d'une plaquette de silicium monocristallin 10 sur laquelle on a fait croître par épitaxie une couche de germanium monocristallin 12 d'une épaisseur pouvant être supérieure au micromètre. Le silicium monocristallin est orienté, par exemple selon l'orientation (100) qui est l'orientation habituellement utilisée dans les filières de semiconducteurs. Le germanium monocristallin 12 reproduit l'information cristalline de la plaquette 10 de silicium monocristallin et présente une direction d'orientation semblable à celle du silicium.

Selon une variante de l'invention, la plaquette de silicium monocristallin 10 peut consister en la couche supérieure d'une structure du type substrat sur isolant (SOI). La couche de germanium 12 peut en outre être réalisée par tout procédé connu, et, en particulier, peut consister en une succession de couches d'un alliage de silicium et de germanium, SiGe, où la concentration atomique en germanium augmente depuis la valeur nulle jusqu'à 100% au fur et à mesure que l'on s'éloigne de la plaquette de silicium 10.

Pour une telle couche 12 de germanium monocristallin, il est connu qu'au-delà d'une épaisseur suffisante, la densité surfacique de défauts, en particulier de dislocations émergentes, est faible, typiquement inférieure à 10⁶ cm-². La référence 13 représente la portion de la couche de germanium 12 voisine de la plaquette de silicium 10 pour laquelle la densité surfacique de défauts est supérieure à des valeurs acceptables. La portion 13 de la couche de germanium 12 a typiquement une épaisseur de l'ordre de 300 nanomètres.

En figure 1B, on a gravé dans la couche de germanium 12 une ouverture 14 dont les dimensions sont légèrement supérieures aux dimensions de la zone active d'AsGa que l'on souhaite réaliser. A titre d'exemple, la section de l'ouverture 14 peut être un carré ou un rectangle dont les côtés mesurent moins de 10 micromètres. L'ouverture 14 peut faire partie d'un ensemble d'ouvertures réalisées simultanément dans la couche de germanium 12 et dont chacune est associée à une région d'AsGa que l'on souhaite former. La gravure utilisée peut être une gravure sèche réalisée après le dépôt d'une résine photosensible sur la couche de germanium 12, l'insolation de la résine pour définir la répartition des ouvertures 14 aux emplacements où l'on souhaite réaliser des zones actives du composé III-V, et enfin la révélation de la résine.

Le fond 16 de l'ouverture 14 obtenu avec une telle gravure est typiquement sensiblement plat et correspond à un plan (100) de croissance du germanium. La profondeur de l'ouverture 14 est inférieure à l'épaisseur totale de la couche de germanium 12 diminuée de l'épaisseur de la portion 13 de façon à assurer l'absence de dislocations émergentes sur le fond 16.

La figure 1C représente la structure obtenue une fois que le fond 16 de l'ouverture 14 a été altéré. Ceci peut être obtenu en modifiant les paramètres d'une gravure ionique réactive pour favoriser les redépôts au fond de l'ouverture 14. On obtient par exemple deux faces inclinées 18, 20 en forme de toit, chaque face 18, 20 étant globalement inclinée d'un angle environ de 6° par rapport à un plan d'orientation (100) du germanium. Chaque face 18, 20 se compose en pratique d'une succession de "marches" à l'échelle des plans atomiques du silicium.

Selon une variante, on peut former une unique face inclinée de 6° par rapport à un plan d'orientation (100) du germanium, ou bien un relief en creux avec deux faces inclinées de 6° par rapport à un plan d'orientation (100) du germanium.

En figure 1D, on a fait croître de l'AsGa sur les faces inclinées 18, 20 de façon à former une région 22 monocristalline d'AsGa. L'épaisseur de la région 22 peut être suffisamment importante, par exemple supérieure à 1 micromètre, pour que la forme altérée du fond 16 de l'ouverture 14 soit sensiblement lissée en surface de la région 22. De préférence, l'AsGa est amené à croître au dessus de la surface de la couche de germanium 12 et la croissance est suivie d'un aplanissement, par exemple par polissage mécano-chimique. Un dispositif optoélectronique ou un circuit rapide peut ensuite être défini dans la région 22 selon l'application souhaitée.

Les figures 2A à 2D illustrent les étapes d'un second mode de réalisation selon l'invention.

Selon le second mode, comme cela est représenté sur la figure 2A, la couche de germanium monocristallin 12 formée sur la plaquette 10 de silicium monocristallin est recouverte d'une couche d'oxyde de silicium 24 d'une épaisseur par exemple de l'ordre de 200 nm, dont la surface 25 est sensiblement plane.

En figure 2B, la couche d'oxyde de silicium 24 a été gravée pour former une zone non plane 26 au niveau de l'emplacement où l'on souhaite former une zone active d'AsGa. La zone non plane 26 peut, par exemple, avoir la forme d'un toit à deux pans inclinés 27, 28, chaque pan étant incliné d'environ 6 degrés par rapport à la surface plane de la couche d'oxyde 24. La forme en toit peut être obtenue en recouvrant la couche d'oxyde de silicium 24 d'un masque, en réalisant dans le masque une ouverture au niveau de la zone à graver, un îlot de masque étant laissé au centre de l'ouverture, et en gravant de façon isotrope la couche d'oxyde de silicium 24 au travers de l'ouverture. La présence de l'îlot entraîne la formation des pans inclinés.

En figure 2C, la couche d'oxyde de silicium 24 a été gravée jusqu'à la couche de germanium 12 pour ne laisser qu'une zone de relief 30 constituée d'oxyde de silicium en surface de la couche de germanium 12. La zone de relief 30 reproduit la forme de la zone non plane 26 réalisée à l'étape précédente. Un masque 31 a été déposé sur la couche de germanium 12 et la zone de relief 30. Une ouverture 32, réalisée dans le masque 31, expose la zone de relief 30, le masque 31 pouvant éventuellement légèrement recouvrir la périphérie de la zone de relief 30.

En figure 2D, on a gravé par l'ouverture 32 du masque 31 le relief 30 et la couche de germanium 12 monocristallin par un procédé de gravure anisotrope utilisant un produit gravant sensiblement à la même vitesse l'oxyde de silicium et le germanium de façon à former une ouverture 33 dans la couche de germanium 12 dont le fond 34 reproduit la forme du relief 30. L'étape de formation de la région monocristalline d'AsGa dans l'ouverture 32 est identique à ce qui a été décrit précédemment.

On peut, selon les applications recherchées, faire croître de façon connue sur la zone d'AsGa d'autres composés III-V dont la croissance directe sur le germanium est délicate, par exemple du InAsGa.

L'invention a été décrite dans le cadre de la formation d'AsGa. Bien entendu, le présent procédé peut être mis en oeuvre pour la croissance de tout composé III-V dont le paramètre de maille est compatible avec celui du germanium.

La présente invention comporte de nombreux avantages.

Premièrement, elle permet la réalisation de zones actives d'un composé III-V monocristallin sur une plaquette de silicium.

Deuxièmement, elle permet la réalisation de zones actives d'un composé III-V monocristallin dont la surface est de l'ordre de quelques dizaines de micromètres carré, ce qui correspond actuellement aux dimensions requises pour la réalisation de dispositifs optoélectroniques ou de circuits rapides.

Troisièmement, les modes de réalisation précédemment décrits mettent en oeuvre des techniques couramment utilisées lors de la réalisation de circuits intégrés classiques sur une plaquette de silicium et peuvent ainsi être facilement intégrés à des filières classiques.

Bien entendu, la présente invention est susceptible de diverses variantes et modifications qui apparaîtront à l'homme de l'art. En particulier, dans le second mode de réalisation, la couche d'oxyde de silicium peut être remplacée par du nitrure Si₃N₄ ou des composés du type SI-O-N.

## Revendications

1. Procédé de croissance d'une région (22) monocristalline d'un composé III-V sur une surface correspondant à un plan cristallographique d'un substrat (10) de silicium mono-cristallin, comportant les étapes suivantes :
faire croître par épitaxie sur le substrat une couche (12) de germanium monocristallin ;
graver dans une partie de l'épaisseur de la couche de germanium une ouverture (14, 33) dont le fond (34) correspond à une unique face inclinée par rapport à ladite surface ou à plusieurs faces inclinées (18, 20) par rapport à ladite surface ; et
faire croître le composé III-V monocristallin sur le fond de l'ouverture.

2. Procédé selon la revendication 1, dans lequel le substrat (10) de silicium monocristallin est orienté (100) et ladite ou lesdites faces inclinées (18, 20) sont inclinées d'un angle de sensiblement 5 à 7 degrés par rapport à ladite surface.

3. Procédé selon la revendication 1, dans lequel le substrat (10) de silicium monocristallin est orienté (100) et le fond (34) de l'ouverture (14, 33) comprend deux faces (18,20) inclinées de sensiblement 5 à 7 degrés par rapport à ladite surface.

4. Procédé selon la revendication 1, comportant en outre l'étape consistant à faire croître sur le substrat (10) de silicium monocristallin au moins une couche d'un alliage de silicium et de germanium sur laquelle on fait croître la couche de germanium.

5. Procédé selon la revendication 1, comportant en outre l'étape consistant à faire croître une couche d'oxyde (24) sur la couche de germanium (12) et à graver ladite couche d'oxyde de façon à former une zone de relief (30) sur ladite couche d'oxyde, la forme de la surface de ladite zone de relief étant transférée par gravure dans la couche de germanium.

6. Procédé selon la revendication 1, dans lequel l'épaisseur de la couche de germanium (12) séparant le fond (34) de l'ouverture (14, 33) et le substrat (10) de silicium monocristallin est supérieure à 300 nanomètres.

7. Procédé selon la revendication 1, dans lequel l'ouverture (14, 33) a une section dont l'aire est de quelques dizaines de micromètres carrés.

8. Procédé selon la revendication 1, dans lequel le composé III-V est de l'arséniure de gallium.

9. Dispositif comprenant un substrat (10) de silicium monocristallin comportant une surface correspondant à un plan cristallographique recouverte d'une couche de germanium (12) monocristallin, **caractérisé en ce que** la couche de germanium comporte au moins une ouverture (14, 33) dont la profondeur est inférieure à l'épaisseur de la couche de germanium, le fond (34) de l'ouverture correspondant à une unique face inclinée par rapport à ladite surface ou à plusieurs faces inclinées (18, 20) par rapport à ladite surface, ladite ouverture contenant un composé III-V.

10. Dispositif selon la revendication 9, dans lequel un composant électronique est formé dans le composé III-V.

## Claims

1. A method for growing a single-crystal region (22) of a III-V compound on a surface corresponding to a crystallographic plane of a single-crystal silicon substrate (10), comprising the steps of:
growing by epitaxy on the substrate a single-crystal germanium layer (12);
etching in a portion of the thickness of the germanium layer an opening (14, 33), the bottom (34) of which corresponds to a single surface inclined with respect to said cristallographic plane or to several surfaces (18, 20) inclined with respect to said cristallographic plane; and
growing the single-crystal III-V compound on the bottom of the opening.

2. The method of claim 1, wherein the single-crystal silicon substrate (10) has an orientation (100) and said inclined surface(s) (18, 20) is (are) inclined by an angle of substantially from 5 to 7 degrees with respect to said cristallographic plane.

3. The method of claim 1, wherein the single-crystal silicon substrate (10) has an orientation (100) and the bottom (34) of the opening (14, 33) comprises two surfaces (18, 20) inclined by substantially from 5 to 7 degrees with respect to said cristallographic plane.

4. The method of claim 1, further comprising the step of growing on the single-crystal silicon substrate (10) at least one layer of a silicon and germanium alloy on which the germanium layer is grown.

5. The method of claim 1, further comprising the step of growing an oxide layer (24) on the germanium layer (12) and of etching said oxide layer to form a relief area (30) on said oxide layer, the shape of the surface of said relief area being transferred by etching into the germanium layer.

6. The method of claim 1, wherein the thickness of the germanium layer (12) separating the bottom (34) of the opening (14, 33) and the single-crystal silicon substrate (10) is greater than 300 nanometers.

7. The method of claim 1, wherein the opening (14, 33) has a cross-section surface area of a few tens of square micrometers.

8. The method of claim 1, wherein the III-V compound is gallium arsenide.

9. A device comprising a single-crystal silicon substrate (10) comprising a surface corresponding to a crystallographic plane covered with a single-crystal germanium layer (12), wherein the germanium layer comprises at least one opening (14, 33) with a depth smaller than the thickness of the germanium layer, the (34) bottom of the opening corresponding to a single surface inclined with respect to said cristallographic plane or to several surfaces (18, 20) inclined with respect to said cristallographic plane, said opening containing a III-V compound.

10. The device of claim 9, wherein an electronic component is formed in the III-V compound.

## Patentansprüche

1. Ein Verfahren zum Aufwachsen bzw. Züchten einer Einkristall-Region (22) einer III-V-Verbindung auf einer Oberfläche, die einer kristallographischen Ebene eines Einkristall-Silizium-Substrats (10) entspricht, wobei das Verfahren die folgenden Schritte aufweist:
Epitaxial-Wachsen einer Einkristall-Germanium-Schicht (12) auf das Substrat;
Einätzen in einem Teil der Dicke der Germanium-Schicht einer Öffnung (14, 33), deren Boden (34) einer einzelnen Oberfläche entspricht, die bezüglich der kristallographischen Ebene geneigt ist oder mehreren Oberflächen (18, 20) entspricht, die bezüglich der kristallographischen Ebene geneigt sind; und
Aufwachsen der Einkristall-III-V-Verbindung auf dem Boden der Öffnung.

2. Verfahren nach Anspruch 1, wobei das Einkristall-Silizium-Substrat (10) eine Orientierung (100) besitzt und die geneigte(n) Öfmung(en) (18, 20) in einem Winkel von Wesentlichen 5 bis 7 Grad bezüglich der kristallographischen Ebene geneigt ist (sind).

3. Verfahren nach Anspruch 1, wobei das Einkristall-Silizium-Substrat (10) eine Orientierung (100) besitzt und der Boden (34) der Öffnung (14, 33) zwei Oberflächen (18, 20) aufweist, die in einem Winkel von im Wesentlichen 5 bis 7 Grad bezüglich der kristallographischen Ebene geneigt sind.

4. Verfahren nach Anspruch 1, das weiterhin den Schritt des Aufwachsens des Einkristall-Silizium-Substrats (10) von zumindest einer Schicht einer Silizium- und Germanium-Legierung aufweist, auf der die Germanium-Schicht aufgewachsen wird.

5. Verfahren nach Anspruch 1, das weiterhin den Schritt des Aufwachsens einer Oxidschicht (24) auf der Germanium-Schicht (12) und das Ätzen der Oxidschicht um einen Entspannungsbereich (30) auf der Oxidschicht zu bilden, aufweist, wobei die Form der Oberfläche des Entspannungsbereichs (relief area) durch Ätzen in die Germanium-Schicht transferiert wird,

6. Verfahren nach Anspruch 1, wobei die Dicke der Germanium-Schicht (12), die den Boden (34) der Öffnung (14, 33) und das Einkristall-Silizium-Substrat (10) trennt, größer als 300 Nanometer ist.

7. Verfahren nach Anspruch 1, wobei die Öffnung (14, 33) eine Quersehnittsfläche von wenigen Zehnteln von Quadratmikrometern besitzt.

8. Verfahren nach Anspruch 1, wobei die III-V-Verbindung Gallium-Arsenid ist.

9. Ein Gerät, das ein Einkristall-Silizium-Substrat (10) aufweist, das eine Oberfläche aufweist, entsprechend zu einer kristallographischen Ebene, abgedeckt mit einer Einkristall-Germanium-Schicht (12), wobei die Germanfum-Schicht zumindest eine Öffnung (14, 33) mit einer Tiefe, die kleiner ist als die Dicke der Germanfum-Schicht, aufweist, wobei der Boden (34) der Öffnung einer einzetne Oberfläche, die bezüglich der kristallographischen Ebene geneigt ist oder mehreren Oberflächen (18, 20), die bezüglich der kristallgraphischen Ebene geneigt sind, entspricht bzw. entsprechen, wobei die Öffnung eine III-V-Verbindung enthält.

10. Gerät nach Anspruch 9, wobei ein elektronisches BautAil in der lll-V-Verbindung gebildet wird.
